Europäisches Patentamt

European Patent Office

Office européen des brevets

(11) Publication number: **0 501 270 A1**

# EUROPEAN PATENT APPLICATION

(21) Application number: **92102621.7**

(22) Date of filing: **17.02.92**

(51) Int. Cl.5: **H01B 1/22**, C09J 163/00

(30) Priority: **25.02.91 JP 53794/91**
**29.05.91 JP 126286/91**

(43) Date of publication of application:
**02.09.92 Bulletin 92/36**

(84) Designated Contracting States:
**DE FR GB**

(71) Applicant: **FUJI POLYMER INDUSTRIES CO., LTD.**
**11-Go, 21-Ban, 5-chome, Chiyoda, Naka-ku**
**Nagoya-shi, Aichi-ken 460(JP)**

(72) Inventor: **Fujimoto, Mitsuhiro**
**401, 2-Go, 14-Ban, Kosakahonmachi 1-chome**
**Toyota-Shi, Aichi-Ken 471(JP)**
Inventor: **Suzuki, Yoichi**
**67, Nakamachi-Nakagou**
**Toyota-Shi, Aichi-Ken 471(JP)**
Inventor: **Koizumi, Masakazu**
**134-108, 1-Go, 1-Ban, Homigaoka 5-chome**
**Toyota-Shi, Aichi-Ken 470-03(JP)**

(74) Representative: **Kador & Partner**
**Corneliusstrasse 15**
**W-8000 München 5(DE)**

(54) **Electronic device using a uniaxial conductive adhesive composition.**

(57) Disclosed is a uniaxial conductive adhesive for electrically connecting an electric part and a circuit substrate or connecting circuit substrates together, the adhesive composition containing at least an adhesive matric resin, a conductive material and a coupling agent, the matrix resin being a one-component epoxy-denatured thermosetting resin. The uniaxial conductive adhesive composition also the adhesive composition containing at least an adhesive matrix resin, a conductive material and a coupling agent, the adhesive matric resin being composed of a uni-component epoxy-denatured thermosetting resin and a thermoplastic resin. Accoding to the invention a highly reliable, superhigh density connected circuit product, which is excellent in the resistance against high temperature and high relative humidity and repairability and can not be obtained with the conventional uniaxial conductive adhesive.

Figure-1

## FEILD OF THE PRESENT INVENTION

This invention relates to uniaxial conductive adhesive compositions and, more particularly, to uniaxial conductive adhesive compositions suitably used for the assembling of electronic device parts, connection of electronic device parts to electronic circuit boards and connection of electronic circuit boards.

## BACKGROUND OF THE INVENTION

Japanese Patent Laid Open 74205/1976 discloses a connection method using uniaxial conductive adhesives for connecting electronic device parts with connection terminals thereof arranged at a fine pitch (e.g. 5 circuits per millimeter) as in liquid crystal display glass substrates, FPC (flexible printed circuits) and circuit substrates.

Many conventional uniaxial conductive adhesives are prepared by randomly dispersing conductive particles in an adhesive matrix resin composed of a thermosetting and a thermoplastic resin, and are used by processing them into the form of a paste or a film.

In use, such a uniaxial conductive adhesive is provided between opposed circuits to bond these circuits together by means of pressure and heat application, thereby effecting electric connection of the circuits to each other and also providing electric insulation between the adjacent circuits. Such uniaxial conductive adhesive is capable of repair with an organic solvent such as acetone or with an alcohol-based washing agent for re-using the pertinent circuit after thermal bonding.

However, the above prior art adhesives which use a thermoplastic resin incorporated in a matrix resin pose problems in the resistance of the connected circuit product against high temperature and high relative humidity. More specifically, they undergo thermal swelling during shelf life, thus deteriorating the contact of the conductive particles with the circuit part and causing failure of conduction. This means that they provide for low reliability of conduction.

This invention has an object of providing an uniaxial conductive adhesive composition which permits improvement of the resistance against high temperature and high relative humidity. The adhesive composition provides for easy repair and permits high reliability circuit connection, thus precluding the problems in the prior art.

## SUMMARY OF THE INVENTION

An objective of the invention is to provide a uniaxial conductive adhesive for electrically connecting an electric part and a circuit substrate or for connecting circuit substrates together, the adhesive composition containing at least an adhesive matrix resin, a conductive material and a coupling agent, the matrix resin being a one-component epoxy-denatured thermosetting resin.

It is preferable in this invention that the conductive material contains of metal particles or metal-coating resin particles.

It is preferable in this invention that the conductive material contains of a mixture of metal particles and metal-coating organic polymer particles, the mean diameter ratio of the metal-coating organic polymer particles to the metal particles being 1.0 to a range of 0.3 to 1.0.

It is preferable in this invention that the adhesive composition is in the form of a film or paste.

It is preferable in this invention that the coupling agent is an epoxy-based silane coupling agent.

It is preferable in this invention that the adhesive composition contains an acrylonitrile rubber or acrylic acid resin containing a carboxyl group.

Another objective of this invention is to provide a uniaxial conductive adhesive composition for electrically connecting an electric part and a circuit substrate or connecting circuit substrates together, the adhesive composition containing at least an adhesive matrix resin, a conductive material and a coupling agent, the adhesive matrix resin being composed of a one-component epoxy-denatured thermosetting resin and a thermoplastic resin.

It is preferable in this invention that the thermoplastic resin contains at least a urethane resin.

In order to obtain reliable conduction of the connected circuit product, the uniaxial conductive adhesive suitably comprises metal or metal-coating resin particles. To obtain further reliable conduction of the connected circuit product, the uniaxial conductive adhesive suitably comprises a mixture of metal particles and metal-coating organic polymer particles having a mean particle diameter ratio of the metal-coating organic polymer particles to the metal particle being 1.0 to a range of 0.3 to 1.0. When bonding pressure is applied to such an adhesive, the metal-coating organic polymer particles are flattened or deformed and are arranged in the direction of electric conduction.

The adhesive composition is suitably in the form of a paste or a film, preferably a film, for convenient handling.

The adhesive composition includes a coupling agent. Any coupling agent may be used, such as aminosilane, vinylsilane and titanium-based coupling agents. Epoxy-based silane coupling agents are preferred to obtain further improved relative humidity resistance. More preferably, $\gamma$-glycidoxyp-ropyltrialkoxysilane, which contains epoxy and hydrolytic capable methoxy groups as functional groups, is used for the improvement of the relative humidity resistance. A suitable amount of the coupling agent is about 0.1 to 7 % by weight.

The adhesive composition suitably contains acrylonitrile rubber or acrylic acid resin containing a carboxyl group for obtaining improved dispersion of the conductive particles in the adhesive matrix resin and also for obtaining improved film formation.

According to a first mode of the invention, a uniaxial conductive adhesive composition is obtainable, which can prevent reduction of the adhesive force in a high temperature, high relative humidity environment. The adhesive composition provides for a broad range of connection conditions, is highly reliabie, permits super-high density circuit connection, and provides for easy repair. The adhesive is particularly useful as a one-component epoxy-denatured thermosetting resin (one-part adhesive). These resins do not readily react at room temperature and are hardened by heating to a predetermined temperature. They, therefore, provide for excellent room temperature shelf stability. The one-component epoxy-denatured thermosetting resins are preferably those obtained by denaturing epoxy resin with two or more different resins, e.g., phenol, urea, etc.

The coupling agent used according to the invention prevents the reduction of the adhesive force under a high relative humidity condition. For example, the adhesion between a liquid crystal display glass substrate and FPC is not greatly reduced even under a high relative humidity condition.

According to a second mode of the invention, a uniaxial conductive adhesive composition, which is excellently repairable is obtainable.

## BREIF DESCRIPTION OF THE DRAWINGS

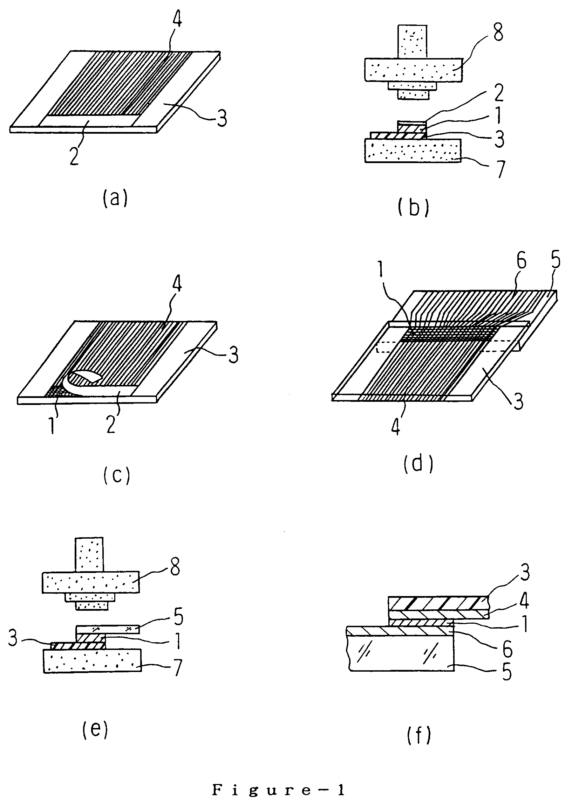

Figures 1(a) through 1(f) are views illustrating a process of bonding the adhesive composition film of the invention to a circuit part of an FPC and connecting the bonded system to NESA glass.

## DETAILED DESCRIPTION OF THE INVENTION

The adhesive matrix resin used according to the invention is excellent as an electrical insulator. In addition, it is suitably fluid such that it can flow through a gap between two opposed parts which are to be connected together. The resin can be hardened by heat, light, an electron beam, etc. or solidified by cooling to form a firm adhesive layer. Further, it is easily "repairable", i.e., it is removable for repair of opposed circuits which have been improperly repaired, thus permitting re-use of circuits, as well as being capable of retaining conductivity when preserved under an elevated temperature condition.

The one-component (uni-component) epoxy-denatured thermosetting resin (one-part adhesive) compared to a two-component epoxy thermosetting resin, which is a combination of a hardening catalyst, e.g., amine, and an epoxy resin dose not readily react at room temperature, but can be hardened when heated to a predetermined temperature. The adhesive according to the invention is less subject to one-component epoxy-denatured thermosetting resin viscosity changes during production and can ensure stable performance. Further, it can excellently hold conductivity of the connected circuit parts when preserved under an elevated temperature condition.

Suitable examples of the one-component epoxy-denatured thermosetting resin are those obtainable by denaturing epoxy resins with one or more resins selected from the group consisting of epoxy, alkid, phenol, melamine, guanamine and urea resins and non-drying aliphatic acids. These epoxy resin products are, of course, by no means limiting.

Examples of the thermoplastic resin which is incorporated in the uni-solution epoxy-denatured thermosetting resin are mixtures of members of the group consisting of copolymers of acrylic acid, polyurethane, polyester, butyral resins, ethylene-vinyl acetate copolymer, maleic acid-denatured ethylene-vinyl acetate copolymer, styrene-butadiene copolymer, and so forth.

Examples of the thermoplastic resin according to the second mode of the invention are also those noted above, although not limiting, particularly, urethane resins are preferred from the standpoint of reliable conduction. Suitable examples of the urethane resin are those obainable by reacting at least one member of a main component group consisting of hexamethylene di-isocyanate, tolylendi-isocyanate, isophorone di-isocyanate, phenylmethane di-isocyanate, etc. with at least one member of the group consisting of polyester polyol, polyether polyol, castor oil, etc. These examples, however, are by no means limitating, and other well-known urethane resins may be extensively used as well. The urethane resin suitably has an average molecular weight of 50,000 or above and also a softening temperature of from 110 °C to 160 °C, preferably from 110 °C to 150 °C. Urethane resins having softening temperatures above 160 °C are unsuitable even if their average molecular weight is less than 50,000, because their flow can be difficultly caused at the usual connection temperature.

The propotion of the matrix resin in the adhesive composition is not particularly limited, but from the standpoint of adhesion and reliable insulation it is suitably 99 to 65 %, preferably 95 to 97 %, by weight of solid.

The proportion of the thermoplastic resin in the adhesive matrix resin is not particularly limited, but from the standpoint of repairability and reliable conduction during preservation at an elevated temperature it is suitably 20 to 80 %, preferably 40 to 70 %, by weight of solid. The proportion of the urethane resin can be suitably selected in a range satisfying the above proportion range of the thermoplastic resin, but from the standpoints of pronounced improvement of the reliable conduction during perservation at an elevated temperature and the repairability, it is suitably incorporated by 40 % by weight or more than 40 % by weight of solid in the thermoplastic resin.

The conductive material used according to the invention is not particularly limited. Suitably, however, highly conductive metal particles or metal-coating organic polymer particles or mixtures of these particles are used.

Suitable examples of the material of the metal particles are platinum, gold, silver, nickel, cobalt, copper, tin, aluminum, palladium, etc. These metals can be used either alone or as a mixture of two or more of them. Further, in addition to the single metal compositions, it is possible to suitably use such alloys as solder or such metal as nickel or copper with gold plating. The above examples of the metal particles are by no means limitating.

The mean diameter of the metal particles is not limited. From the standpoint of the reliable conduction and insulation, however, it is suitably in a range from 0.3 to 40 microns, preferably from 0.5 to 16 microns.

The metal particles are suitably flaky or spherical, preferably spherical. Suitably, they have a uniform diameter.

The polymer component of the metal-coating organic polymer particles may be selected from a comprehensive group consisting of such thermosetting resins as epoxy and phenol, such thermoplastic resins as polyamide, polyimide, polyamideimide, polyester and polystyrene, and various rubber varieties such as polybutadiene, nitrile rubber and butadiene styrene rubber. Epoxy resins are preferred in that excellently plated particles can be obtained from them.

The coating metal may be for example gold, platinum, silver, tin, nickel, zinc, aluminum, palladium or cobalt. In addition to the uni-component composition coatings, coatings of alloys such as silver may be used. It is further suitable from the standpoint of the blance between the cost and performance to use a laminated coating, for example, a coating having an innermost nickel layer and an outermost gold layer. A laminated layer may also be used, which has an outermost solder layer. The metal-coating organic polymer particles may be formed thereon by plating, spattering, vacuum deposition, ion plating etc.

The amount of the coating metal suitably does not exceed the organic polymer in volume.

The mean diameter of the metal-coating organic polymer particles is not limited, but from the standpoint of the reliable conduction and insulation by connection of surfaces it is suitably in a range between 1 and 40 microns, preferably 1 to 20 microns.

From the standpoint of the reliable conduction and handling, mixtures of metal particles and metal-coating organic polymer particles are suitably used. In this case, the mean diameter ratio between the metal particles and the metal-coating organic polymer particles is not limited. In order to prevent separation of or damage to the metal coating, as well as permitting adequate deformation of the metal-coating organic polymer particles and ensuring reliable conduction, however, the mean metal particle diameter is suitably in a range of 0.1 to 1.0 micron, preferably 0.3 to 0.8 micron.

The proportion of the conductive material, i.e., metal particles and/or metal-coating organic polymer particles, in the adhesive composition is not particularly limited. In order to maintain the individual particles to be substantially independent to provide insulation of the whole adhesive layer in the lateral direction so as to ensure reliable insulation between adjacent circuits of connected circuit product and to provide for reliable conduction, however, the proportion is suitably in a range of 1 to 35 %, preferably 5 to 25 %, by weight of solid.

Where metal and metal-coating organic polymer particles are used as a mixture, it is suitable from the standpoint of reliable conduction to use from 0.5 % to 30 % by weight of metal particles and from 99.5 %

4

to 70 % by weight of metal-coating organic polymer particles.

In use, the uniaxial conductive adhesive composition according to the invention is usually coated in the form of a paste containing the conductive material on the entire surface or at least terminal sections of one of the two parts to be connected together. If necessary, it is dried to remove the solvent. Then the part with the coating is pressed together with the other part with the coating between the two parts using a hot press, thus obtaining a connected circuit product. Alternatively, two parts are pressed with the uniaxial conductive adhesive composition sandwiched as an adhesive film between them using a hot press to obtain a connected circuit product.

The paste is usually obtained by diluting the material with a diluting agent. As the diluting agent may be used such organic solvents as ketones, alcohols, cellosolves, dioxanes, aromatic hydrocarbons and ethyl acetate. When using the uniaxial conductive adhesive composition as an adhesive film, the paste is prepared as above. Then a film is formed by removing the solvent. The film can also be formed directly by a fusion film formation process using the diluting agent. These methods of film formation, however, are by no means limitating.

Where the uniaxial conductive adhesive composition is used as a film, the thickness is suitably in a range of 1 to 100 microns, preferably 1 to 50 microns.

It is further suitable for the relative humidity resistance improvement to add from 0.1 to 7 % by weight of the coupling agent. Further, to obtain improved dispersion of conductive particles and improved film formation, from 0.1 to 20 % by weight of an acrylonitrile rubber or acrylic acid resin containing a carboxyl group to the adhesive composition.

Now, an example of use of the adhesive composition according to the invention will be described with reference to the drawings. Figures 1(a) to 1(f) illustrate a process in which the adhesive composition according to the invention is applied as a film to a circuit part, e.g., a FPC, which is then connected to NESA glass. In these Figures, designatd at 1 is the adhesive composition according to the invention in the form of a film, at 2 is a protective film, at 3 is a FPC, at 4 a circuit part on the FPC, at 5 is a NESA glass, at 6 is a circuit part on the NESA glass, at 7 is a lower heater, and at 8 is an upper heater. As shown in Figure 1(a), an adhesive composition film 1 is temporarily applied to a circuit 4 on a FPC 3. Then, as shown in Figure 1(b), it is temporarily bonded using heaters 7 and 8. Then, as shown in Figure 1(c), a protective film 2 is peeled off.

Then, as shown in Figure 1(d), the FPC 3 is inverted, and a ciruit part 6 formed on a NESA glass 5 is positioned to register with the adhesive composition film 1. In this state, regular bonding is effected using the heaters 7 and 8, as shown in Figure 1(e). Figure 1(f) shows the connected circuit product thus obtained, in which the circuit 4 on the FPC 3 and the circuit 6 on the glass plate (NESA glass) 5 are connected and integrated together by the intervening adhesive composition 1. In this structure, the adhesive composition 1 is conductive only in the perpendicular direction.

Accoding to the invention a highly reliable, superhigh density connected circuit product is obtained which is excellent in resistance against high temperature and high relative humidity and repairability. Such a circuit can not be obtained with the conventional uniaxial conductive adhesive. It is further possible to obtain a connected circuit product, which is superior to the prior art products in reliability of electric conduction during elevated temperature conditions. Thus, it is possible to obtain connection of a glass substrate of, for example, a liquid crystal display wired at a high density, a FPC connection of circuit substrates and direct mounting of an IC chip or similar small part to a circuit substrate.

The invention will be further described in conjunction with examples thereof without any limitation intended.

Example 1

A composition comprising 16.3 % by weight of one-solution epoxy-denatured thermosetting resin ("SJ9372-001" manufactured by Kansai Paint Co., Ltd.), 1.6 % by weight of carboxyl-containing acrylonitrile rubber ("NBR1072J" manufactured by Nihon Zeon Co., Ltd.), 1.5 % by weight of gold-coating (plating) polystyrene particles with an average particle diameter of 6 microns ("AULOPEARL SU21-SB60" manufactured by Matsuura Co., Ltd. and Okuno Seiyaku Kogyo Co., Ltd.), 1.8 % by weight of $\gamma$-glycidoxypropyl trimethoxysilane ("SH6040" manufactured by Toray Dow Corning Silicone Co., Ltd.), 19.6 % by weight of methylethylketone, 50.0 % by weight of methyl cellosolve and 9.2 % by weight of chlorobenzene, was charged into an agitator for dispersion, and then coated on the surface of a base using a coater/drier, thus obtaining a film having a thickness of 22 microns.

The base was a a polypropylene film.

A test circuit (FPC) having terminals arranged at a pitch of 5 terminals/mm was produced from a polyimide film clad with a 35-micron copper foil. Another test circuit having terminals arranged at a pitch of 5 terminals/mm was produced from a 30 Ω/□ ITO (Ω/□ is sheet resistivity value, and ITO is indium-tin oxide, transparent electrode) glass. The film noted above was temporarily bonded to a terminal section of the FPC by pressing it against the terminal section at 100 °C and with a pressure of 10 kg/cm$^2$ for 5 seconds using a hot press and then immediately cooling it down.

Then, the base was separated, and the terminal sections of the FPC and ITO glass were registered and pressed at 150 °C and with a pressure of 20 kg/cm$^2$ for 20 seconds, immediately followed by cooling-down. A connected circuit product was obtained in this way, and it was tested under a high temperature, high relative humidity condition of 80 °C and 90 % RH. The result is shown in Table 1.

Example 2

A composition comprising 8.9 % by weight of one-solution epoxy-denatured thermosetting resin ("SJ9372-001" manufactured by Kansai Paint Co., Ltd.), 8.1 % by weight of polyurethane resin (LQ-3121; thermal softening point 150°C; average molecular weight from 500,000 to 600,000; by Sanyo Chemical Industries Ltd.), 0.6 % by weight of carboxyl-containing acrylonitrile rubber ("NBR1072J" manufactured by Nihon Zeon Co., Ltd.), 2.1 % by weight of gold-coating (plating) polystyrene particles with a average particle diameter of 6 microns ("AULOPEARL SU21-SB60" manufactured by Matsuura Co., Ltd. and Okuno Seiyaku Kogyo Co., Ltd.), 1.0 % by weight of γ-glycidoxypropyl trimethoxysilane ("SH6040" manufactured by Toray Dow Corning Silicone Co., Ltd.), 38.0 % by weight of methylethylketone, 35.9 % by weight of methyl cellosolve and 5.1 % by weight of chlorobenzene, was charged into an agitator for dispersion, and then coated on the surface of a base using a coater/drier, thus obtaining a film having a thickness of 22 microns.

The base was a a polypropylene film.

A test circuit (FPC) having terminals arranged at a pitch of 5 terminals/mm was produced from a polyimide film clad with a 35-micron copper foil. Another test circuit having terminals arranged at a pitch of 5 terminals/mm was produced from a 30 Ω/□ ITO (indium-tin oxide, transparent electrode) glass. The film noted above was temporarily bonded to a terminal section of the FPC by pressing it against the terminal section at 100 °C at a pressure of 10 kg/cm$^2$ for 5 seconds using a hot press and then immediately cooling it down.

Then, the base was separated, and the terminal sections of the FPC and ITO glass were registered and pressed at 210 °C at a pressure of 20 kg/cm$^2$ for 20 seconds, immediately followed by cooling-down. A connected circuit product was obtained in this way, and it was tested under a high temperature, high relative humidity condition of 80 °C and 90 % RH. The result is shown in Table 1.

Table 1

| Result | | | Example 1 | Example 2 |
|---|---|---|---|---|
| Value of resistance: | Initial | | 10.0 | 10.9 |
| | ($\Omega$) | | (11.3, 9.5) | (12.3, 9.7) |
| | | | Badness point | Badness point |
| | | | Open point=0 | Open point=0 |
| | After test | | 36.6 | 55.6 |
| | ($\Omega$) | | (53.6, 27.5) | (111.3, 39.1) |
| | | | Badness point | Badness point |
| | | | Open point=0 | Open point=8 |
| Adherence: | Initial (kg/cm) | | 0.75 | 1.22 |
| | After test (kg/cm) | | 2.13 | 2.01 |
| Repair property: | Acetone | | Good | Good |
| | Ligroin | | Good | Good |

Measurement condition

(1) FPC: One ounce, 5 lines/mm; ITO glass plate: 30 ohms ($\Omega$) or below

(2) Transcription: 100℃, 10 kg/cm$^2$, 5 seconds

(3) Main adherence: 150 ℃, 20 kg/cm$^2$, 20 seconds

(4) Current value: 1 mA between ITO and FPC circuit

Numerals results are given as average values with maximum and minimum values in parenthesis. (Total number of measurements = 30.) Repair property is measured by ITO peel off in the direction of the FPC circuit after main adherence. Adhering material contacting the circuit side is washed away by an organic solution. Adherernce is measured by ITO peel off (pull rate: 30mm/min) in the square direction of the FPC circuit after main adherence of the FPC to the glass plate.

Example 3, Comparative example 1

A composition comprising 8.8 % by weight of one-solution epoxy-denatured thermosetting resin ("TE1710" manufactured by Toray Co., Ltd.), 1.8 % by weight of acrylic resin ("LU-651 manufactured by Toray Co., Ltd.), 7.0 % by weight of urethane resin ("SANPLEN LOS-A" thermal softening point; 150°C, average molecular weight from 500,000 to 600,000; by Sanyo Chemical Industries Ltd.), 2.6 % by weight of nikel-coating (plating) epoxy resin particles with an average particle diameter of 6 microns (manufactured by Toray Co., Ltd.), 0.9 % by weight of nikel-powder with an average particle diameter of 3 microns (type:287 manufactured by Nobamet Co., Ltd.), 1.0 % by weight of $\gamma$-glycidoxypropyl trimethoxysilane ("SH6040" manufactured by Toray Dow Corning Silicone Co., Ltd.), 78.9 % by weight of methylethylketone, was charged into an agitator for dispersion, and then coated on the surface of a base using a coater/drier, thus obtaining a film having a thickness of 20 microns.

Two test circuits each having terminals arranged at a patch of 10 terminals/mm were produced from a polyimide film clad with a 18-micron copper film. The paste noted above was screen printed on a terminal section of one of these test circuits. The mean thickness of the coating film after drying was 20 microns. Then, the terminal sections were registered and pressed together at 150 °C at a poressure of 30 kg/cm$^2$ for 20 seconds using a hot press, immediately followed by cooling-down (Example 3).

The connected circuit product thus obtained had a conduction resistance of 1.0 ohm ($\Omega$) or below. The insulation resistance between its adjacent terminals was $10^{10}$ ohms ($\Omega$) or above. This connected circuit product retained the conducting and insulating properties noted above after preservation at 80 °C for 1,000 hours.

For comparison, a connected circuit product was produced in the same manner as in this example except for that the uni-solution epoxy-denatured thermosetting resin was not used (Comparative example 1).

The conduction resistances of the connected circuit product in this example and the comparative example 1 connected circuit product were measured after maintaining at 80 °C for 1,000 hours.

The results are shown in Table 2.

The comparative connected circuit product had inferior conduction reliability and lacked reliability as a superhigh density electric connector. In contrast, the connected circuit product using the uniaxial conductive adhesive according to the invention had excellent conduction reliability and permitted superhigh density electric connection.

Example 4

A composition comprising 52 % by weight of one-solution epoxy-denatured thermosetting resin ("TE1710" manufactured by Toray Co., Ltd.), 35 % by weight of maleic acid-denatured ethylene-vinyl acetate copolymer (HPR-103, manufactured Mitsui Du Pont Co., Ltd.), 13 % by weight of nikel-powder with a average particle diameter of 2.5 microns (type:255 manufactured by Nobamet Co., Ltd.), 1.0 % by weight of $\gamma$-grlcidoxypropyl trimethoxysilane ("SH6040" manufactured by Toray Dow Corning Silicone Co., Ltd.), was melt blending in an agitator, and then coated on the surface of a base using a hot plate press, thus obtaining a film having a thickness of 20 microns.

Two test circuits each having terminals arranged at a patch of 10 terminals/mm were produced from a polyimide film clad with a 18-micron copper film. The paste noted above was screen printed on a terminal section of one of these test circuits as in example 3. The mean thickness of the coating film after drying was 20 microns. The terminal sections were registered and pressed together at 160 °C at a pressure of 30 kg/cm$^2$ for 20 seconds using a hot press, immediately followed by cooling-down.

The connected circuit product using the uniaxial conductive adhesive according to the example had excellent conduction reliability and permitted superhigh density electric connection as in example 3.

The conduction resistances of the connected circuit product in this example product were measure after maintaining at 80 °C for 1,000 hours. The results are shown in Table 2.

Table 2

| Adhering material (80 °C) | Value of resistance ($\Omega$) | | | |
|---|---|---|---|---|
| | Initial | 250 hrs. | 500 hrs. | 1,000hrs. |
| Example 3 | 0.42 | 0.56 | 0.74 | 0.95 |
| Example 4 | 0.56 | 0.75 | 0.83 | 0.90 |
| Comparative ex. 1 | 1.02 | 3.65 | - | - |
| [Measurement used Degital micro meter produced by Keithley Co., Ltd. Comparative example 1 was nonconductive where no values are indicated.] | | | | |

Example 5

A composition comprising 8.9 % by weight of one-solution epoxy-denatured thermosetting resin ("SJ9372-001" manufactured by Kansai Paint Co., Ltd.), 8.1 % by weight of polyurethane resin (LQ-3121, thermal softening point, 150 °C; average molecular weight from 500,000 to 600,000; by Sanyo Chemical Industries Ltd.), 0.9 % by weight of carboxyl-containing acrylonitrile rubber ("NBR1072J" manufactured by Nihon Zeon Co., Ltd.), 2.1 % by weight of gold-coating (plating) polystyrene particles with an average particle diameter of 6 microns ("AULOPEARL SU20-SB60" manufactured by Matsuura Co., Ltd. and Okuno Seiyaku Kogyo Co., Ltd.), 1.0 % by weight of $\gamma$-glycidoxypropyl trimethoxysilane ("SH6040" manufactured by Toray Dow Corning Silicone Co., Ltd.), 38.0 % by weight of methylethylketone, 35.9 % by weight of methyl cellosolve and 5.1 % by weight of chlorobenzene, was dispersed in an agitator, and then coated on the surface of a base using a coater/drier, thus obtaining a film of the composition having a thickness of 22 microns.

The base was a a polypropylene film.

A test circuit (FPC) having terminals arranged at a pitch of 5 terminals/mm was produced from a polyimide film clad with a 35-micron copper foil. Another test circuit having terminals arranged at a pitch of 5 terminals/mm was produced from a 30 $\Omega$/ $\square$ ITO (indium-tin oxide, transparent electrode) glass. The film noted above was temporarily bonded to a terminal section of the FPC by pressing it against the terminal section at 130 °C and with a pressure of 10 kg/cm$^2$ for 5 seconds using a hot press and then immediately cooling it down.

Then, the base was separated, and the terminal sections of the FPC and ITO glass were registered and pressed at 150 °C at a pressure of 20 kg/cm$^2$ for 20 seconds, immediately followed by cooling-down. The connected circuit product thus obtained had a conduction resistance of 30 ohms ( $\Omega$) or below. The insulation resistance between its adjacent terminals was $10^{10}$ ohms ($\Omega$) or above.

These connected circuit products were preserved under various conditions, and the results are shown in Table 3. Table 4 shows shows adhesion when connected circuit products are produced in the manner in Example 3 from adhesive films preserved for different periods of time. Figure 5 shows results of evaluation of the adhesion resisting the relative humidity where a silane coupling agent was and was not added.

Table 3

| Measurement term | Measurement condition | Result |
|---|---|---|
| (1) Value of resistance (Ω) | | |
| (Initial value) | | 8.8 |
| * Thermal test | 125 ℃...1000hr | 35.8 |
| * Low temperature | -40 ℃...1000hr | 27.2 |
| * Heat shock | -40 ℃←→+100℃...100times[1] | 36.7 |
| * High temp. & humidity | 70 ℃,95 %RH ...1000hr | 62.0 |
| * $SO_2$ gas | 25 ppm, 25℃,75 %RH ...500hr | 25.0 |
| * $H_2S$ gas | 5 ppm,40 ℃,80 %RH ...500hr | 30.9 |
| * Expose the outdoors | 1000hr | 19.3 |
| * Dipping in hot water | 70 ℃...24hr | 55.9 |
| (2) Insulation resistance (Ω) | | |
| (Initial value) | | $10^{10}<$ |
| * Thermal test | 125 ℃...1000hr | $10^9<$ |
| * Low temperature | -40 ℃...1000hr | $10^9<$ |
| * Heat shock | -40 ℃←→+100℃...100times[1] | $10^9<$ |
| * High temp. & humidity | 70 ℃, 95 %RH...1000hr | $10^9<$ |
| * Migration | 40 ℃, 95 %RH, 25V ...1000hr | $10^9<$ |
| (3) Adhere property(kg/cm) | | |
| (Initial value) | | 1.22 |
| * Thermal test | 125 ℃...1000hr | 0.97 |
| * Low temperature | -40 ℃...1000hr | 1.13 |
| * Heat shock | -40 ℃←→+100℃...10times [1] | 1.68 |
| * High temp. & humidity | 70 ℃,95 %RH ...1000hr | 1.91 |
| * $SO_2$ gas | 25ppm, 25 ℃, 75 %RH...500hr | 1.01 |
| * $H_2S$ gas | 5ppm, 40 ℃, 80 %RH...500hr | 1.76 |
| * Expose the outdoors | 1000hr | 1.08 |
| * Dipping in hot water | 70 ℃...24hr | 1.00 |

## Measurement condition

(1)   FPC: One ounce, 5 lines/mm or 10 lines/mm;

   ITO glass plate: 30 ohms  ($\Omega$) or below

(2)   Transcription: 130 ℃, 10 kg/cm$^2$ , 5 seconds

(3)   Main adherence: 150℃, 20 kg/cm$^2$ , 20 seconds

(4)   Current value: 1 mA between ITO and FPC circuit

(5)   100times [1)]  : -40 ℃ 30 min ←→ 100  ℃ 30 min

(6)   Value of resistance: FPC One ounce, 5 lines/mm or 10 lines/mm;

   ITO glass plate: 30 ohms  ($\Omega$) or below, test number=30

(7)   Insulation resistance; DC 100 V between FPC adjacent circuit

(8)   Adhererence: ITO peel off (pull rate: 30mm/min) in the square direction of a FPC circuit after main adherence of the FPC to the glass plate.

Table 4

| Measurement point | Pregress time (hours) (kg/cm) | | | | | | |
|---|---|---|---|---|---|---|---|
| | 0 | 500 | 1,000 | 1,500 | 2,000 | 2,500 | 3,000 |
| 1 (kg/cm) | 1.1 | 1.1 | 1.0 | 1.0 | 1.0 | 0.6 | 0.5 |
| 2 (kg/cm) | 1.2 | 1.1 | 1.0 | 1.1 | 1.0 | 0.6 | 0.8 |
| 3 (kg/cm) | 1.1 | 1.0 | 1.0 | 1.0 | 0.7 | 1.0 | 1.1 |
| 4 (kg/cm) | 1.1 | 1.1 | 0.9 | 1.1 | 0.8 | 0.8 | 0.5 |
| 5 (kg/cm) | 1.1 | 1.1 | 1.0 | 1.0 | 0.8 | 1.1 | 0.7 |
| Average value(kg/cm) | 1.1 | 1.1 | 1.0 | 1.0 | 0.9 | 0.8 | 0.7 |

Where pregress time (hours) is measured at room temperature and room humidity.

Table 5

| Adherence (kg/cm) | Initial time | After 1 day dipped 60 ° C water |
|---|---|---|
| Silane coupling agent 1.0 wt % | 1.1 to 1.2 | 1.0 to 1.1 |
| Non Silane coupling agent | 1.0 to 1.1 | 0.5 to 0.6 |

In the above embodiment, a connected circuit product having excellent resistance against high temperature and high relative humidity can be obtained as shown in Table 5. In addition, the uniaxial conductive adhesive composition provides a broad range of conditions for connection and permits easy connecting operations. Thus, it can be handled very excellently.

Further, the connected circuit product is excellently heat resistant and durable against cooling and heating. Further, it is possible to obtain a high density connection (of 10 circuits/mm or above) by increasing the density of the electric part.

As shown above, in a preferred example of the invention a uni-component epoxy-denatured thermosetting resin is used as the matrix resin and is incorporated by about 65 to 95 % by weight of the total composition. As the conductive material, about 5 to 25 % by weight of metal particles or metal-coating (plating) resin particles are suitably incorporated. As the coupling agent, about 0.1 to 7 % by weight of alkoxysilane containing an epoxy group is suitably incorporated. When these conditions are met, it is possible to obtain improved resistance against high temperature and high relative humidity and repairability of the adhesive composition (in the forms of a paste, a film, etc.) for connecting electric part and circuit base or circuit bases together and also obtain highly reliable, excellently superhigh density circuit connection.

As has been shown, the invention is greatly beneficial to industry.

The invention may be embodied in other specific forms without departing from the spirit or essential characteristics thereof. The present embodiment is to be considered in all respects as illustrative and not restrictive, the scope of the invention being indicated by the appended claims rather than by the foregoing description and all changes which come within the meaning and range of equivalency of the claims are intended to be embraced therein.

## Claims

1. An uniaxial conductive adhesive for electrically connecting an electric part to a circuit substrate or for connecting circuit substrates together, said adhesive composition comprising an adhesive matrix resin, a conductive material and a coupling agent, said matrix resin being a uni-component epoxy-denatured thermosetting resin.

2. The uniaxial cnductive adhesive according to claim 1, wherein said conductive material contains metal particles or metal-coating resin particles.

3. The uniaxial conductive adhesive according to claim 1, wherein said conductive material contains a mixture of metal particles and metal-coating organic polymer particles, the mean diameter ratio of said metal-coating organic polymer particles to said metal particles being 1.0 to a range of 0.3 to 1.0.

4. The uniaxial conductive adhesive according to claim 1, wherein said adhesive composition is in the form of a film or paste.

5. The uniaxial conductive adhesive composition according to claim 1, wherein said coupling agent is an epoxy-based silane coupling agent.

6. The uniaxial conductive adhesive composition according to claim 1, wherein said adhesive composition contains an acrylonitrile rubber or acrylic acid resin containing a carboxyl group.

7. An uniaxial conductive adhesive composition for electrically connecting an electric part and a circuit substrate or connecting circuit substrates together, said adhesive composition comprising an adhesive matrix resin, a conductive material and a coupling agent, said adhesive matrix resin containing a one-component epoxy-denatured thermosetting resin and a thermoplastic resin.

8. The uniaxial conductive adhesive composition according to claim 7, wherein said thermoplastic resin contains a urethane resin.

9. The uniaxial cnductive adhesive according to claim 2, wherein said metal-coating resin is metal plating resin particles.

(a)

(b)

(c)

(d)

(e)

(f)

Figure-1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | WORLD PATENTS INDEX LATEST<br>Derwent Publications Ltd., London, GB;<br>AN 91-182062<br>& JP-A-3 110 711 (FUJI KOBUNSHI) 10 May 1991<br>* abstract *<br>--- | 1-4,6-9 | H01B1/22<br>C09J163/00 |
| A | GB-A-2 079 507 (CANON)<br><br>* claims 1-33 *<br>--- | 1,2,4,5,7 | |
| A | DE-A-2 246 658 (HITACHI)<br><br>* page 1, paragraph 2; claims 1-8 *<br><br>----- | 1,2,4,5,7 | |
| | | | TECHNICAL FIELDS SEARCHED (Int. Cl.5 )<br><br>H01B<br>C09J |

The present search report has been drawn up for all claims

| Place of search | Date of completion of the search | Examiner |
|---|---|---|
| THE HAGUE | 04 JUNE 1992 | DROUOT M.C. |